Europäisches Patentamt

European Patent Office

Office européen des brevets

(11) Veröffentlichungsnummer: **0 405 214 A2**

## (12) EUROPÄISCHE PATENTANMELDUNG

(21) Anmeldenummer: 90111006.4

(22) Anmeldetag: 11.06.90

(51) Int. Cl.⁵: **H01L 27/144**, H01L 31/105

(30) Priorität: 27.06.89 DE 3921027

(43) Veröffentlichungstag der Anmeldung:
02.01.91 Patentblatt 91/01

(84) Benannte Vertragsstaaten:
DE FR GB IT

(71) Anmelder: **Siemens Aktiengesellschaft**
**Wittelsbacherplatz 2**
**D-8000 München 2(DE)**

(72) Erfinder: **Albrecht, Helmut, Dr.**
**Wessobrunner Platz 9 a**
**D-8000 München 70(DE)**
Erfinder: **Lauterbach, Christl**
**Rosenstrasse 6**
**D-8011 Siegertsbrunn(DE)**

(54) **Pin-FET-Kombination mit vergrabener p-Schicht.**

(57) pin-FET-Kombination mit auf einem Substrat (1) ganzflächig aufgewachsen einer Grundschicht (2), einer ersten Halbleiterschicht (3) als Absorptionsschicht (20-3) bzw. Pufferschicht (30-3), einer zweiten Halbleiterschicht (4) als Kontaktschicht (20-4) bzw. als Kanalschicht (30-4) und einer dritten Halbleiterschicht (5) als Deckschicht, in der das $p^+$-Gebiet (20-6) der Fotodiode (20) bzw. der Gate-Bereich (30-6) des FET (30) ausgebildet sind, wobei die Grundschicht (2) im Bereich der Fotodiode (20) undotiert oder n-dotiert und im Bereich des FET (30) p-dotiert ist und im Bereich des FET (30) zwischen der Kanalschicht (30-4) und dem Substrat (1) ein ganzflächiger p-dotierter Schichtanteil (7) vorhanden ist.

FIG 1

## PIN-FET-KOMBINATION MIT VERGRABENER P-SCHICHT

Zukünftige Schnittstellen zwischen optischen und elektronischen Komponenten von optischen Datenübertragungssystemem werden monolithisch integrierte optoelektronische Schaltkreise enthalten. Auf der Empfängerseite stellt sich das Problem der Integration von Fotodetektor und Vorverstärker. Gefordert werden gute Kompatbilität der für die verschiedenen Komponenten benötigten Halbleiterschichten und Technologien. Eine Schwierigkeit bei der monolithischen Integration einer Fotodiode mit einem Feldeffekttransistor (FET) liegt in den unterschiedlichen Anforderungen an die Dotierungskonzentrationen und Schichtdicken.

Eine optimierte Fotodiode benötigt für einen hohen externen Quantenwirkungsgrad eine ausreichend dicke Absorptionsschicht aus z.B. n-InGaAs im InGaAsP-Materialsystem mit geringer Restdotierung. Diese nominell undotierte InGaAs-Schicht ist Voraussetzung für eine niedrige Kapazität sowie niedrigen Dunkelstrom und demzufolge gute Rauscheigenschaften. In einer n-dotierten Deckschicht aus InP oder InAlAs ist das $p^+$-Gebiet, in das durch einen ringförmigen p-Kontakt das Licht einfällt, ausgebildet. Zwischen der Absorptionsschicht und dem Substrat aus z.B. semiisolierendem InP:Fe ist eine hochdotierte n-leitende Halbleiterschicht aus z.B. InGaAs, InP oder InAlAs zur Reduzierung des Serienwiderstandes und der Laufzeiteffekte, d.h. die Träger-Transitzeit in der Diode, aufgebracht. Auf dieser hochdotierten Halbleiterschicht ist der n-Kontakt aufgebracht.

Der FET benötigt für eine hohe Steilheit eine hochdotierte n-InGaAs-Schicht als Kanalschicht, die für ein gutes Abschnürverhalten des FETs entsprechend dünn sein muß. Zum Substrat aus z.B. InP:Fe folgt eine niedrig dotierte $n^-$-InGaAs-Schicht als Pufferschicht, die störende Einflüsse vom Substrat (Ausdiffusion von Eisen in die Kanalschicht) verhindert. Auf der Kanalschicht befindet sich der $p^+$-dotierte Gatebereich, der seitlich begrenzt ist und mit einem Kontakt versehen wird. Auf der Kanalschicht sind die Kontakte für Drain- und Source aufgebracht. Bedingung für das Einfügen der Pufferschicht ist, daß das Abschnürverhalten des FETs nicht negativ beeinflußt wird, d.h. diese Pufferschicht darf nicht zu dick (kleiner als $2\mu m$) und die Dotierung nicht zu hoch sein (kleiner als $10^{15} cm^{-3}$). Die Deckschicht, die das Gate bildet, ist n-InP bzw. n-InAlAs und bildet zum InGaAs der Kanalschicht eine Heterobarriere und ermöglicht die Realisierung eines sperrenden Metall-Halbleiter-Überganges als Gate. Diese Schicht hat außerdem den Vorteil, daß aufgrund des höheren Bandabstandes von InP bzw. InAlAs im Vergleich zu InGaAs eine Passivierung des pn-Überganges an der Bauelementeoberfläche die Langzeitstabilität erhöht und Leckströme verringert. Dieser Vorteil gilt sowohl für die Fotodiode (PD) als auch für den FET.

Um bei der Integration von PD und FET komplizierte Epitaxieverfahren (z.B. flächenselektive Epitaxie) bzw. Abtragen einzelner Epitaxieschichten zu vermeiden, werden Kompromisse in bezug auf die Schichtstruktur geschlossen.

In der deutschen Offenlegungsschrift DE 37 11 617 A1 ist eine PD-FET-Kombination beschrieben, bei der eine niedrig n-dotierte und darauf eine hoch n-dotierte InGaAs-Schicht ganzflächig aufgewachsen sind und im Bereich der Fotodiode im Substrat eine $n^+$-Implantation selektiv vor der Epitaxie erzeugt worden ist.

Aufgabe der vorliegenden Erfindung ist es, eine monolithisch integrierte Fotodiode-FET-Kombination anzugeben, die einfacher als die bekannten Kombinationen herstellbar ist und bei der gleichzeitig die für die PD und den FET unterschiedlichen Anforderungen an Dotierungskonzentration und Schichtdicke berücksichtigt sind.

Diese Aufgabe wird mit der Fotodiode-FET-Kombination mit den Merkmalen des Anspruches 1, alternativ mit den Merkmalen des Anspruches 2 gelöst.

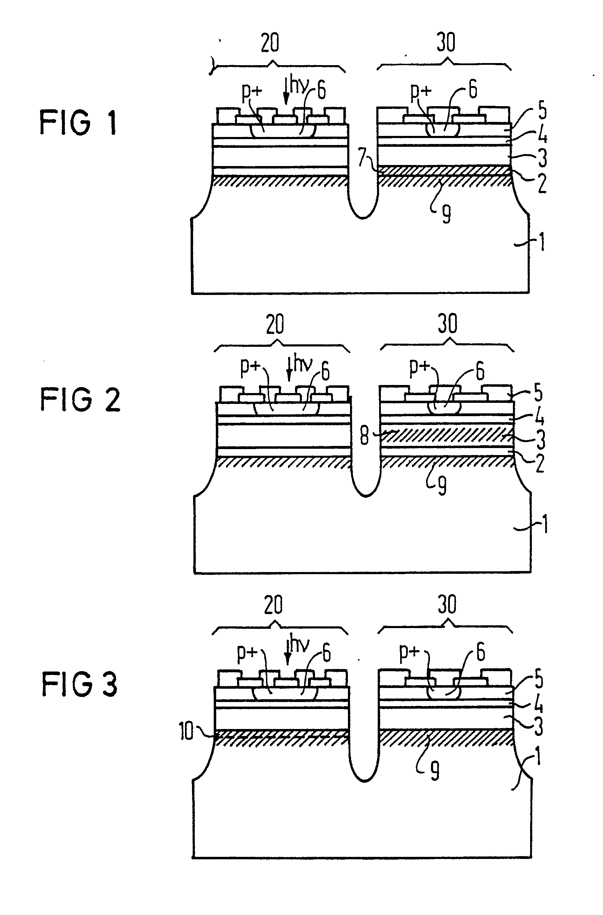

Es folgt eine Beschreibung der erfindungsgemäßen Fotodiode-FET-Kombination anhand dreier in den Figuren 1 bis 3 im Querschnitt dargestellter, besonders vorteilhafter Ausführungsformen.

Bei dem Aufbau nach Fig. 1 sind auf einem Substrat 1 nacheinander eine Grundschicht 2 aus Halbleitermaterial und weiter eine erste Halbleiterschicht 3, eine zweite Halbleiterschicht 4 und eine dritte Halbleiterschicht 5 jeweils ganzflächig aufgewachsen. Diese Schichtstruktur ist durch einen senkrechten Trenngraben in den Bereich der Fotodiode 20 und den Bereich des FET 30 unterteilt. Die erste Halbleiterschicht 3 bildet im Bereich der Fotodiode 20 eine Absorptionsschicht 20-3 und im Bereich des FET 30 eine Pufferschicht 30-3. Die zweite Halbleiterschicht 4 bildet im Bereich der Fotodiode 20 eine Kontaktschicht 20-4 und im Bereich des FET 30 eine Kanalschicht 30-4. Die dritte Halbleiterschicht 5 bildet im Bereich der Fotodiode 20 und im Bereich des FET 30 jeweils eine Deckschicht. Das Substrat 1 ist InP und semiisolierend (z.B. InP:Fe). Die Grundschicht 2 hat eine Dicke von 0,5 $\mu m$ bis 3 $\mu m$ und ist InP, InGaAs, InAlAs, InGaAsP oder InGaAlAs. Mit den Halbleitermaterialsystemen InAlAs, InGaAsP oder InGaAlAs kann diese Grundschicht 2 als optische Wellenleiterschicht ausgebildet sein. Diese Grundschicht 2 ist für die Fotodiode 20 vorgesehen und undotiert bzw. n-dotiert mit einer Dotierungshöhe unter $10^{18}$cm$^{-3}$. Da diese Grundschicht 2 ohne zusätzliche Maßnahmen die Eigenschaften des FETs wesentlich verschlechtern würde (kein Abschnürverhalten, große Kanalleckströme), ist im Bereich des FET 30 in diese Grundschicht 2 mittels einer selektiven p-Dotierung (p-Ionenimplantation oder p-Diffusion) ein für p-Leitung dotierter Schichtanteil 7 ausgebildet. Im Bereich des FET 30 ist dieser p-dotierte Schichtanteil 7 ganzflächig vorhanden. Bei der Herstellung wird die Epitaxie nach dem Aufwachsen der Grundschicht 2 unterbrochen und dieser p-dotierte Schichtanteil 7 durch selektive p-Dotierung hergestellt. In einem zweiten Epitaxieschritt werden die weiteren Halbleiterschichten 3,4,5 aufgewachsen. Die erste und zweite Halbleiterschicht 3,4 sind InGaAs. Die dritte Halbleiterschicht 5 ist InP, InAlAs, InGaAsP oder InGaAlAs. Die erste Halbleiterschicht 3 ist niedrig n$^-$-leitend dotiert und die zweite Halbleiterschicht 4 hoch n$^+$-leitend dotiert. Die p$^+$-dotierten Bereiche 6 sind durch eine p-Ionenimplantation oder p-Diffusion in der als Deckschicht fungierenden dritten Halbleiterschicht 5 eingebracht. Diese dritte Halbleiterschicht 5 ist außerhalb der p$^+$-dotierten Bereiche 6 undotiert oder n-dotiert. Bei der Herstellung kann alternativ eine p-dotierte dritte Halbleiterschicht 5 als Deckschicht aufgewachsen werden (Dotierung kleiner als $10^{19}$cm$^{-3}$), die außerhalb der p$^+$-Bereiche 6 nachträglich für n-Leitung dotiert wird und die in Verbindung mit der Kanalschicht 30-4 (aus z.B. n$^+$-InGaAs) einen pn-Heteroübergang bildet.

Die Vorteile dieses erfindungsgemäßen vergrabenen selektiven pn-Überganges im Bereich des FETs 30 zwischen der Grundschicht 30-2 (im Bereich des FETs 30 p-dotiert) und der darauf aufgewachsenen Pufferschicht 30-3 (n$^-$-dotiert) sind:

1. Die Abschnüreigenschaften des FETs werden wesentlich verbessert und die Kurzkanaleffekte reduziert (K. Steiner, U. Seiler, K. Heime: "Influence of p-InP buffer layers on submicron InGaAs/InP junction field-effect transistors", Appl. Phys. Lett. 53 , 2513-2515, (1988)).

2. Die n$^-$-InGaAs-Pufferschicht 30-3 kann durch die Ausbildung der Raumladungszone des vergrabenen pn-Überganges eine größere Schichtdicke aufweisen als bei herkömmlichen Halbleiterschichtstrukturen für FETs. Damit weist diese erste Halbleiterschicht 3 eine ausreichende Dikke auf, um als Absorptionsschicht 20-3 der Fotodiode 20 einen hohen Quantenwirkungsgrad und eine niedrige Diodenkapazität zu ermöglichen. Auch der Einfluß der Dotierung in der ersten Halbleiterschicht 3 (n$^-$-InGaAs-Absorptionsschicht 20-3) wird weniger kritisch (Dotierungshöhe unter $10^{16}$cm$^{-3}$).

Bei der in Fig. 2 dargestellten Struktur ist der p-dotierte Schichtanteil 8 des FET 30 nach dem Aufwachsen der Grundschicht 2 und der drei Halbleiterschichten 3, 4, 5 mit Hilfe einer tiefen selektiven p-Ionenimplantation hergestellt worden.

Dieser p-dotierte Schichtanteil 8 kann wie in der Fig. 2 dargestellt in der ersten Halbleiterschicht 3 liegen oder darunter in der Grundschicht 2.

In den Fig. 1 und 2 ist zusätzlich ein p-dotierter oberer Schichtanteil 9 des Substrates eingezeichnet. Das semiisolierende Substrat 1 ist an der überwachsenen Oberfläche durch eine ganzflächige p-Ionenimplantation bzw. p-Diffusion p-leitend gemacht. Dieser obere p-dotierte Schichtanteil 9 des Substrates 1 bildet zusammen mit der Grundschicht 2 bzw. im Fall der Fig. 1 mit dem im Bereich der Fotodiode 20 befindlichen Anteil dieser Grundschicht 2 und der Pufferschicht 30-3 im Bereich des FET 30 einen sperrenden pn-Übergang. Durch diesen sperrenden pn-Übergang werden die Isolationseigenschaften des Substrates 1 verbessert und Nebenschlußströme über das Substrat zwischen Fotodiode 20 und FET 30 verringert. Statt des p-dotierten Schichtanteils 9 an der Oberfläche des Substrates 1 kann auch eine weitere p-dotierte Schicht zwischen Substrat 1 und Grundschicht 2 aufgewachsen sein.

Bei der alternativen Ausführungsform nach Fig. 3 ist ein sperrender pn-Übergang zwischen der ersten Halbleiterschicht 3 und dem Substrat 1 vorgesehen. Hierbei ist durch eine ganzflächige p-Ionenimplantation bzw. p-Diffusion in das Substrat 1 an der überwachsenen Oberfläche des Substrates 1 ein p-dotierter Schichtanteil 9 ausgebildet. Auf die Grundschicht 2 und den p-dotierten Schichtanteil zwischen der Kanalschicht 30-4 und dem Subtrat 1 im Bereich des FET 30 kann hierbei verzichtet werden. Zur Verbesserung der Anwachsbedingungen der ersten, zweiten und dritten Halbleiterschicht 3,4,5 kann eine Grundschicht 2 aus Halbleitermaterial sehr dünn (kleiner 50 nm) aufgewachsen werden. Stattdessen ist im Bereich der Fotodiode 20 ganzflächig der oberste Schichtanteil dieses p-dotierten Schichtanteiles 9 n-dotiert. Der p-dotierte Schichtanteil 9 des Substrates 1 grenzt also im Bereich des FET 30 unmittelbar an die Pufferschicht 30-3. Im Bereich der Fotodiode 20 befindet sich ganzflächig zwischen dem p-dotierten Schichtanteil 9 des Substrates 1 und der Absorptionsschicht 20-3 (Anteil der ersten Halbleiterschicht 3 im Bereich der Fotodiode 20) dieser n$^+$-dotierte Schichtanteil 10 des Substrates 1. Dieser n-dotierte Schichtanteil 10 des Substrates wird nach der ganzflächigen p-Dotierung durch eine selektive n$^+$-Ionenimplantation bzw. n$^+$-Diffusion in das Substrat 1 im Bereich der späteren Fotodiode 20 hergestellt. Die Halbleiterschichten 3,4,5 können daher ohne Unterbrechung epitaktisch nacheinander aufgewachsen werden. Daraus ergibt sich eine wesentliche Vereinfachung des Herstellungsprozesses.

Die Vorzeichen der Dotierung (n- bzw. p-Dotierung) der vorstehend beschriebenen Ausführungsbeispiele können auch umgekehrt sein. Alle beschriebenen Strukturen sind geeignet zur Integration weiterer optoelektronischer Bauelemente wie z.B. optische Wellenleiter (Grundschicht 2) und/oder einer zusätzlichen pin-Fotodiode zur Kombination von Doppel-pin-Fotodiode und FET.

Bei allen beschriebenen Strukturen (Fig. 1 bis 3) erfolgt der elektrische Anschluß der Halbleiterbauelemente mittels einer Kontaktmetallisierung. Dafür werden für den p- und n-Kontakt getrennte Kontaktbedampfungen mit unterschiedlichen Metallisierungsfolgen und zusätzlichen Legierungsschritten benötigt. Eine Verbesserung der n-Kontakteigenschaften von Fotodiode und FET (Drain und Source) erzielt man durch Abtragen der Deckschicht (dritte Halbleiterschicht 5) im Bereich dieser Kontakte bis zur Kanalschicht 30-4 bzw. bis zur Kontaktschicht 20-4. Zur Verbesserung der p-Kontakteigenschaften kann noch zwischen der Deckschicht und der Metallisierungsebene eine epitaktisch gewachsene Kontaktschicht (z.B. InGaAs) eingefügt werden. Der oder die Trenngräben werden jeweils soweit in das Substrat 1 hineingezogen, daß der p-dotierte Schichtanteil 9 - sofern vorhanden - vollständig durchtrennt wird, d.h. der Trenngraben bis in das semiisolierende Material des Substrates 1 reicht.

**Ansprüche**

1. Fotodiode-FET-Kombination mit übereinander auf einem Substrat (1) aus III-V-Halbleitermaterial aufgewachsen
- einer Absorptionsschicht (20-3) mit niedriger Dotierung für einen ersten Leitungstyp,
- einer Kontaktschicht (20-4) mit hoher Dotierung für diesen ersten Leitungstyp und
- einer Deckschicht (20-5) mit einem darin ausgebildeten Bereich (20-6), der von der Oberfläche dieser Deckschicht (20-5) bis zur Kontaktschicht (20-4) reicht und für den entgegengesetzten zweiten Leitungstyp dotiert ist,
- wobei diese drei Schichten (20-3,20-4,20-5) für die Fotodiode (20) vorgesehen sind,
- mit ebenfalls übereinander auf dem Substrat (1) aufgewachsen
- einer Pufferschicht (30-3) mit niedriger Dotierung für den ersten Leitungstyp,
- einer Kanalschicht (30-4) mit hoher Dotierung für den ersten Leitungstyp und
- einer Deckschicht (30-5) mit einem darin ausgebildeten Gate-Bereich (30-6),
- wobei diese drei Schichten (30-3,30-4,30-5) für den FET (30) vorgesehen sind und

- mit Kontakten für elektrischen Anschluß der Fotodiode (20) und des FET (30),
**dadurch gekennzeichnet,**
- daß auf dem Substrat (1) ganzflächig eine Grundschicht (2) aus Halbleitermaterial aufgewachsen ist,
- daß darauf eine erste Halbleiterschicht (3) ganzflächig aufgewachsen ist, die im Bereich der Fotodiode (20) die Absorptionsschicht (20-3) und im Bereich des FET (30) die Pufferschicht (30-3) bildet,
- daß darauf eine zweite Halbleiterschicht (4) ganzflächig aufgewachsen ist, die im Bereich der Fotodiode (20) die Kontaktschicht (20-4) und im Bereich des FET (30) die Kanalschicht (30-4) bildet,
- daß darauf eine dritte Halbleiterschicht (5) ganzflächig auf gewachsen ist, die die jeweilige Deckschicht (20-5,30-5) bildet,
- daß zwischen dem Substrat (1) und der Kanalschicht (30-4) ein für den zweiten Leitungstyp dotierter Schichtanteil (7,8) ganzflächig im Bereich des FET (30) vorhanden ist und
- daß die Fotodiode (20) und der FET (30) durch einen bis ins Substrat (1) hineinreichenden Trenngraben voneinander getrennt sind.

2. Fotodiode-FET-Kombination mit übereinander auf einem Substrat (1) aus III-V-Halbleitermaterial aufgewachsen
- einer Absorptionsschicht (20-3) mit niedriger Dotierung für einen ersten Leitungstyp,
- einer Kontaktschicht (20-4) mit hoher Dotierung für diesen ersten Leitungstyp und
- einer Deckschicht (20-5) mit einem darin ausgebildeten Bereich (20-6), der von der Oberfläche dieser Deckschicht (20-5) bis zur Kontaktschicht (20-4) reicht und für den entgegengesetzten zweiten Leitungstyp dotiert ist,
- wobei diese drei Schichten (20-3,20-4,20-5) für die Fotodiode (20) vorgesehen sind,
- mit ebenfalls übereinander auf dem Substrat (1) aufgewachsen,
- einer Pufferschicht (30-3) mit niedriger Dotierung für den ersten Leitungstyp,
- einer Kanalschicht (30-4) mit hoher Dotierung für den ersten Leitungstyp und
- einer Deckschicht (30-5) mit einem darin ausgebildeten Gate-Bereich (30-6),
- wobei diese drei Schichten (30-3,30-4,30-5) für den FET (30) vorgesehen sind, und
- mit Kontakten für elektrischen Anschluß der Fotodiode (20) und des FET (30),
**dadurch gekennzeichnet,**
- daß auf dem Substrat (1) eine erste Halbleiterschicht (3) ganzflächig aufgewachsen ist, die im Bereich der Fotodiode (20) die Absorptionsschicht (20-3) und im Bereich des FET (30) die Pufferschicht (30-3) bildet,
- daß darauf eine zweite Halbleiterschicht (4) ganzflächig aufgewachsen ist, die im Bereich der Fotodiode (20) die Kontaktschicht (20-4) und im Bereich des FET (30) die Kanalschicht (30-4) bildet,

- daß darauf eine dritte Halbleiterschicht (5) ganzflächig aufgewachsen ist, die die jeweilige Deckschicht (20-5,30-5) bildet,

- daß an der überwachsenen Oberfläche des Substrates (1) ein für den zweiten Leitungstyp dotierter Schichtanteil (9) des Substrates (1) ganzflächig vorhanden ist, der im Bereich der Fotodiode (20) durch einen für den ersten Leitungstyp dotierten Schichtanteil (10) des Substrates (1) ganzflächig von der Absorptionsschicht (20-3) getrennt ist und der im Bereich des FET (30) an die Pufferschicht (30-3) ganzflächig angrenzt und

- daß die Fotodiode (20) und der FET (30) durch einen bis ins Substrat (1) hineinreichenden Trenngraben voneinander getrennt sind.

3. Fotodiode-FET-Kombination nach Anspruch 1,
**dadurch gekennzeichnet,**
daß der für den zweiten Leitungstyp dotierte Schichtanteil (7) in der Grundschicht (2) durch selektive Dotierung vor dem Aufwachsen der ersten Halbleiterschicht (3) ausgebildet ist.

4. Fotodiode-FET-Kombination nach Anspruch 1,
**dadurch gekennzeichnet,**
daß der für den zweiten Leitungstyp dotierte Schichtanteil (8) durch selektive Ionenimplantation nach dem Aufwachsen der dritten Halbleiterschicht (5) ausgebildet ist.

5. Fotodiode-FET-Kombination nach einem der Ansprüche 1, 3 oder 4,
**dadurch gekennzeichnet,**
daß an der überwachsenen Oberfläche des Substrates (1) und an die Grundschicht (2) angrenzend eine für den zweiten Leitungstyp dotierter Schichtanteil (9) des Substrates (1) ganzflächig vorhanden ist.

6. Fotodiode-FET-Kombination nach einem der Ansprüche 1, 3 oder 4,
**dadurch gekennzeichnet,**
daß zwischen dem Substrat (1) und der Grundschicht (2) ganzflächig eine für den zweiten Leitungstyp dotierte Sperrschicht aufgewachsen ist.

7. Fotodiode-FET-Kombination nach einem der Ansprüche 1 bis 6,
**dadurch gekennzeichnet,**
daß der erste Leitungstyp n-Leitung und der zweite Leitungstyp p-Leitung ist.

8. Fotodiode-FET-Kombination nach einem der Ansprüche 1 bis 6,
**dadurch gekennzeichnet,**
daß der erste Leitungstyp p-Leitung und der zweite Leitungstyp n-Leitung ist.

FIG 1

FIG 2

FIG 3